# EUROPEAN PATENT SPECIFICATION

(11) **EP 3 455 388 B1**
(45) Date of publication and mention of the grant of the patent: **12.02.2020**
(21) Application number: 17727981.7
(22) Date of filing: 12.05.2017
(51) Int. Cl.: C23C 14/50, C23C 16/458, H01L 21/683, H01L 21/687, B65G 47/92

(54) **ELECTROSTATIC CHUCKING OF COVER GLASS WITH IRREGULAR SURFACE FLATNESS**
ELEKTROSTATISCHES EINSPANNEN VON DECKGLAS MIT UNREGELMÄSSIGER OBERFLÄCHENEBENHEIT
DISPOSITIF DE SERRAGE ÉLECTROSTATIQUE POUR UN VERRE DE COUVERTURE À PLANÉITÉ DE SURFACE IRRÉGULIÈRE

(30) Priority: 12.05.2016 US 201662335350 P
(43) Date of publication of application: 20.03.2019
(73) Proprietor: Corning Incorporated, Corning, New York 14831 (US)
(72) Inventor: BOUGHTON, Daniel Robert, Naples, New York 14512 (US); FAGAN, James Gerard, Painted Post, New York 14870 (US); KEEBLER, Thomas Augustus, Corning, New York 14830 (US)
(74) Representative: Sturm, Christoph
(86) International application number: PCT/US2017/032479
(87) International publication number: WO 2017/197305

(56) References cited:
- JP-A- 2013 026 424
- US-A1- 2013 147 129

## Description

### CROSS-REFERENCE TO RELATED APPLICATIONS

This application claims the benefit of priority under 35 U.S.C. § 119 of U.S. Provisional Application Serial No. 62/335350 filed on May 12, 2016.

### BACKGROUND

The present disclosure relates to the general field of chucking or clamping a substantially two-dimensional (flat or 2D) cover glass substrate and/or a substantially three-dimensional (sometimes referred to as curved or 3D) cover glass substrate, such as to allow physical vapor deposition by which coatings or treatments are applied to the glass substrate. In particular, the present disclosure relates to such chucking by means of an induced electrostatic polarization commonly known as electrostatic chucking or "ESC" for short.

Handheld display glass with treatments is being developed to meet market demands, and such treatments include antimicrobial surface treatments and scratch resistant optical coatings. There exists a need for low manufacturing cost and rapid delivery of such handheld displays and therefore a low-cost, high-volume manufacturing process for producing high performance scratch-resistant optical coatings is desired for both 2D and 3D cover glass substrates. Such manufacturing processes include vacuum coating processes in which the substrates reach a significant temperature due to particle kinetics over the process duration (e.g., up to or even exceeding 230° C), which makes clamping the substrates difficult with conventional techniques, such as adhesive tapes.

ESC is a technology in which a static electric field with planar field lines (produced from a high voltage potential) is applied to parallel electrodes separated by a dielectric and induces molecular dipoles in a substrate. These molecular dipoles align themselves with the externally-applied electric field and are thus attracted cumulatively to the field lines from the electrodes. ESC has been used in other industries/applications, but its application or use in coating processes of glass is believed to be limited.

Electrostatic chucks have several forms, but generally fall within two main categories: (1) unipolar; and (2) bipolar. Generally speaking, a unipolar type has a single electrode embedded in a substrate below a workpiece. For example, as shown in U.S. Published Patent Application Number US20030053282 A1, a wafer is connected to a power supply and the plasma formed over the surface of the wafer forms an electrical connection to the wafer as the return connection to the supply. This type of electrostatic chuck requires the presence of plasma to bond and debond the wafer. As described in U.S. Published Patent Application Number US20030053282 A1, the workpiece is a semiconductor wafer and it appears that such a chuck would not work with a glass substrate unless the glass had a metal coating to act as a conductive layer connected to the plasma.

The second type of electrostatic chuck, a bipolar chuck, generally has at least two electrodes embedded in a dielectric, but separated and carrying opposite potentials. A field is set up between the two electrodes, which are very close to the surface of the chuck. When a substrate, such as a glass sheet, is placed on the chuck the field lines between the electrodes also pass through the glass causing charge separation in the glass and attraction of the glass to the electrodes embedded in the chuck.

Japanese patent publication number JP2007036285A describes a high temperature metal sputtering process on a board/substrate (presumably semiconductor wafer from the title) which is clamped by an electrostatic chuck which is heated from 100° C to 150° C for the sputtering process.

United States Published Patent Application Number US20140034241A1 describes an electrostatic clamping apparatus in a plasma processing chamber used for plasma etch processing of 3-dimensional SiOG substrates (silicon coated glass substrates) used for stacked microprocessor fabrication.

Japanese published patent application number JP2012124362A describes an electrostatic chuck clamping a glass substrate in a sputtering plasma process while controlling the substrate temperature. The thermal control is accomplished by a broadly used technique in the semiconductor industry of using gas, typically He, flowing in microchannels on the ESC surface behind the substrate.

The 2006 article by Choe, Hee-Hwan, "Basic Study of a Glass Substrate in a Dry Etching System," Vacuum 81 (2006) pp. 344-346 discusses the theoretical effect of the electric field from plasma in a reactive ion etch chamber and the backside cooling with He on a glass substrate and the use of an ESC to oppose and overcome these forces.

US 2013/147129 A1 discloses an electrostatic support having a rigid chassis with a plurality of apertures, and resiliently mounted chucking pins which can be moved individually extending through these apertures, whereby the chucking pins move to predetermined postions when pressure is provided.

JP 2013 026424 A discloses electrostatic chucking of substrates.

Surface "flatness" of the electrostatic chuck and the substrate plays an important role in clamping. In some cases, a glass substrate may not be flat (overall) and may be a curved, molded part, such as a 3D cover glass substrate. Generally speaking, there are two types of flatness: overall surface flatness and localized surface flatness. Overall surface flatness relates to the overall shape of the item (workpiece), such as whether the item is planar, curved, cylindrical, etc. Localized surface flatness relates to how planar an object is in a localized area, more or less on a micro level (as opposed to the macro level of overall flatness). As will be described herein, the embodiments of the electrostatic chuck apparatus can be used with a 2D glass substrate that has localized surface flatness variation across its length on the order of up to about 25 µm and 3D glass substrate that has a localized surface flatness variation of up to about 100 µm in its flat region across the length of the glass, as measured by an ATOS Triple Scan (available from GOM mbH of Braunschweig, Germany), after spraying the glass substrate with a white powder paint. In other words, the embodiments of the electrostatic chuck apparatus can be used with such 2D glass substrates or 3D glass substrates that are have a localized surface flatness variation of about 10 µm or more (up to 25 µm or 100 µm, respectively).

Known electrostatic chucks typically have a surface flatness of < 10 µm across their surfaces and presupposes a similar surface flatness on the substrate that is being chucked. The closer the electrodes are to the surface of the substrate, the higher the clamping force. However, a dielectric is needed to cover the electrodes to prevent arcing and of sufficient dielectric strength to permit as thin as possible coating to produce a high clamping force and also permit finishing the coating surface for surface flatness to ensure intimate contact with the substrate to be chucked. This need for flatness does not lend itself to bonding to the 2D and 3D substrates described herein which exhibit a localized surface flatness variation of about 10 µm or more (e.g., localized surface flatness variation up to and including about 25 µm or up to and including 100 µm, respectively, for 2D and 3D substrates).

Accordingly, it can be seen that a need yet remains for a chucking or clamping a substantially two-dimensional (flat or 2D) glass substrate and/or a substantially three-dimensional (sometimes referred to as curved or 3D) glass substrate, despite surface irregularities and/or less than optimal localized surface flatness. It is to the provision of such that the present disclosure is primarily directed.

### SUMMARY OF THE DISCLOSURE

Briefly described, in a first example form the present disclosure relates to embodiments of a chucking apparatus for chucking 3D glass substrates for use in mobile devices. In particular, one or more embodiments of this disclosure relates to an electrostatic chuck designed to have a matrix of small height and azimuthal adjustable pogo-like elements. Each individual adjustable or movable pogo-like element has a small bipolar electrostatic chuck which is in direct contact with the glass. The aggregate of many of these small pogo electrostatic chucks *in toto* provides a sufficient clamping force to hold a glass substrate despite the presence of the localized surface flatness described herein. In some embodiments, the chuck maintains contact with the surface of the glass despite the glass being 2D and having a localized surface flatness variation in the range from about 10 µm to about 25 µm or being 3D and having a localized surface flatness variation in the range from about 10 µm to about 100 µm.

One or more embodiments of this disclosure pertains to an electrostatic chuck apparatus for chucking glass and includes a substantially rigid chassis with a plurality of apertures extending from one side of the chassis to another side of the chassis. A plurality of electrostatic chuck pins extend through the openings and are resiliently mounted to the chassis such that the extent to which the electrostatic chuck pins extend through the chassis is individually variable. With this construction, surface contours of the glass can be followed by the chuck pins, with the electrostatic chuck pins maintaining contact with the surface of the glass despite some localized irregularity in the surface flatness of the glass.

Optionally, the electrostatic chuck pins are spring-mounted to the chassis.

Alternatively, the chassis can include a resilient sheet attached to a rigid panel, and the electrostatic chuck pins can be mounted to the resilient sheet. Optionally, a second rigid panel can be attached to the resilient sheet such that the resilient sheet is sandwiched between the two rigid panels.

In one or more embodiments, the electrostatic chuck pins are substantially cylindrical and they have first and second electrodes separated from one another by a dielectric which maintains a gap between the electrodes. In one or more embodiments, the electrodes are positioned within a ceramic cylinder.

In one or more embodiments, the apparatus is adapted to withstand operating temperatures of up to about 260 degrees centigrade or more.

Optionally, the resilient sheet comprises a PFA fluoropolymer film with a thickness of between about 0.3 millimeters and about 0.5 millimeters and the openings are cylindrical with a diameter of between about 5 millimeters and about 8 millimeters and the pins are cylindrical with a diameter of between about 2 millimeters and about 4 millimeters.

### BRIEF DESCRIPTION OF THE DRAWING FIGURES

**Figure 1** is a schematic illustration of a number of a chucking apparatus according to one or more embodiments of the present disclosure.
**Figure 2A** is a schematic, detailed perspective illustration of a portion of the chucking apparatus of **Figure 1****.**
**Figure 2B** is a schematic, detailed partially cutaway illustration of a portion of the chucking apparatus of **Figure 2A****.**
**Figure 3** is a schematic, detailed, partially cutaway perspective illustration of a portion of the chucking apparatus of **Figure 1****.**
**Figure 3A** is a schematic, detailed illustration of a portion of the chucking apparatus of **Figure 3****.**
**Figure 4A** is a schematic, perspective view of a portion of a chucking apparatus according to one or more embodiments of the present disclosure.
**Figure 4B** is a schematic, perspective view of a portion of a chucking apparatus according to one or more embodiments of the present disclosure.
**Figure 5** is a schematic, perspective view of a chucking apparatus according to one or more embodiments of the present disclosure.
**Figure 6** is a schematic, detailed perspective illustration of a portion of the chucking apparatus of **Figure 5****.**
**Figure 6A** is a schematic, detailed partially cutaway illustration of a portion of the chucking apparatus of **Figure 5****.**

### DETAILED DESCRIPTION

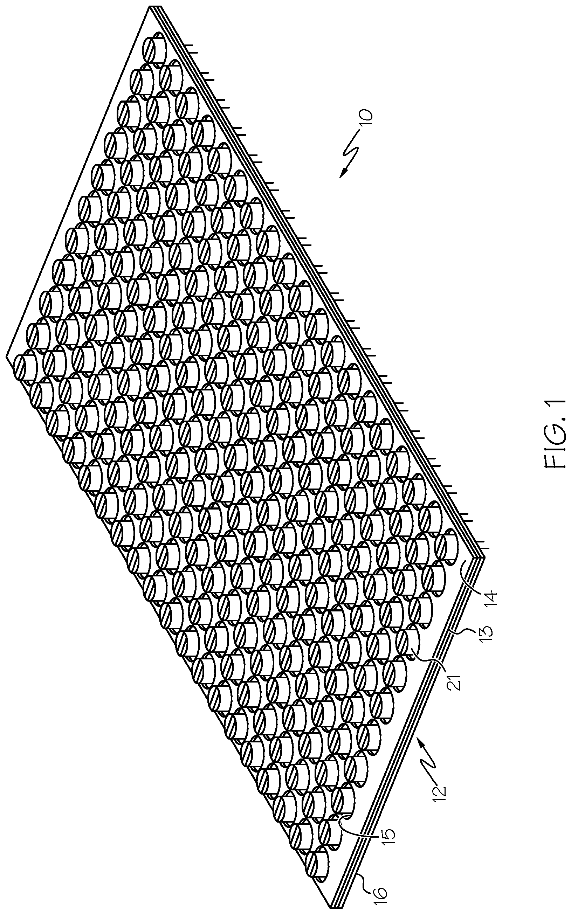

Referring now in detail to the various drawing figures, in which like reference characters represent like parts throughout the several views, **Figures 1-3A** show an electrostatic chuck apparatus 10 for chucking glass and including a substantially rigid chassis 12 with a plurality of apertures 15 extending from one side of the chassis to another side of the chassis. A plurality of electrostatic chuck pins 21 extend through the openings and are resiliently mounted to the chassis 12 such that the extent to which the electrostatic chuck pins 21 extend through the chassis 12 is individually variable. In other words, the chuck pins 21 can be moved up and down, side to side, and pitch and yaw to conform to localized surface irregularity. With this construction, surface contours of the glass can be followed by the electrostatic chuck pins 21, with the electrostatic chuck pins 21 maintaining contact with the surface of the glass despite some variation in localized surface flatness of the glass.

In one or more embodiments, the chassis 12 includes a resilient sheet 13 attached to a rigid panel 14, and the electrostatic chuck pins 21 are mounted to the resilient sheet 13. Optionally, a second rigid panel 16 can be attached to the resilient sheet 13 such that the resilient sheet 13 is sandwiched between the two rigid panels 14, 16. The resilient sheet 13 acts as a suspension to movably attach the pins to the chassis, while allowing the pins to move about as needed to conform to localized surface irregularities. As shown in the figures, the apparatus includes a flexible matrix of miniature pogo-like electrostatic chucks embedded in a flexible mounting.

In one or more specific embodiments, the electrostatic chuck pins 21 are substantially cylindrical bi-polar chucks and they have first and second electrodes 22, 23 separated from one another by a dielectric 24 which maintains a gap between the electrodes. In some embodiments, the electrodes 22, 23 are positioned within a ceramic cylinder 26. The cylinder 26 can bear a circumferential groove 27 about its midpoint for receiving the resilient sheet 13 therein. The size of the aperture in the resilient sheet may be closely matched to the diameter of the cylinder 26 in the bottom of the groove 27. The size of the aperture in the resilient sheet 13 can be slightly larger than, nominally smaller than, or the same size as the size of the diameter of the cylinder in the bottom of the groove 27. Thus, the resilient sheet 13 securely holds the electrostatic chuck pins 21 firmly in place. This construction also facilitates a rapid and inexpensive assembly of the device in that the individual electrostatic chuck pins can be attached, and accurately positioned, simply by pushing an electrostatic chuck pin 21 into a corresponding opening in the resilient sheet 13. Thus, to make the chuck apparatus, a large number of chuck pins can be inserted one at a time into the chassis (or gang assembled). As the pins are pushed into the chassis, the resilient nature of the resilient sheet 13 permits the chuck pins to be pushed in easily until the chuck pins are captured as the resilient sheet 13 is engaged in and captured by the groove 27 formed in the pin 21.

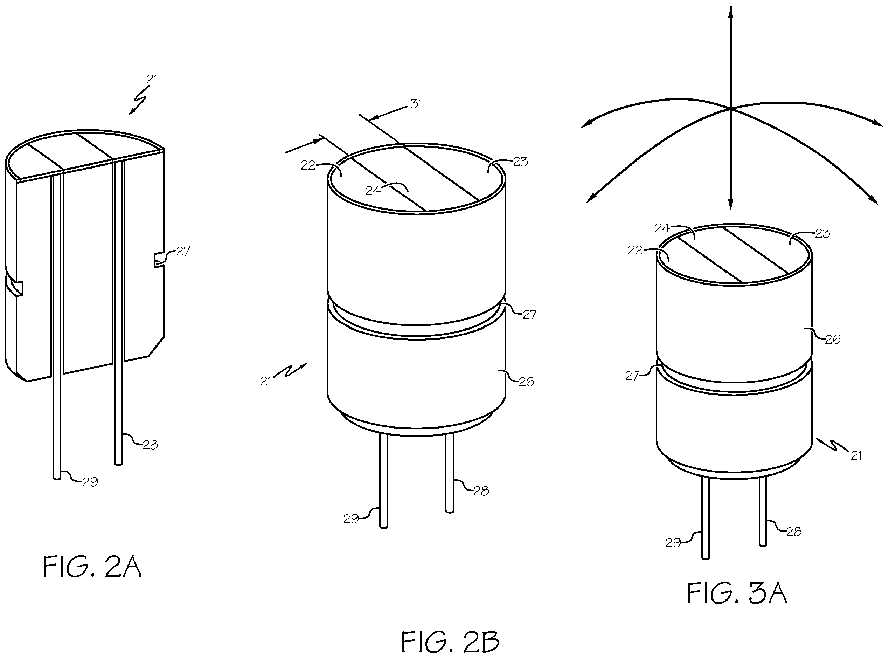

The apparatus according to one or more embodiments of the present disclosure compensates for the irregularity of the substrate surface needs to be achieved. Described in another way, the one or more embodiments described herein may incorporate a number of small pogo-like electrostatic chucks 21, which collectively can provide a substantial clamping force to hold a work piece securely in place. In one or more embodiments, the apparatus includes the electrostatic chuck pins 21, which each consists of two hemispheres of silver, with each hemisphere having an area of about 1.882 mm2. The two hemispheres are mounted into a 3 mm diameter ceramic alumina - Al2O3 - cylinder as shown in **Figures 2A-2B****.** The two silver hemispheres are coated with a 60 µm thick coating of alumina - Al2O3 - coating and polished to a flatness < 10 µm. The two silver electrodes are separated by a 1 mm gap (39.37 mil) 31 which has 418 volts per mil and should be able to withstand 16,456 VDC. A maximum of 3.6 kVDC is applied to each of the electrodes in the pogo electrostatic chuck. Two silver rods (positive and negative leads) 28, 29 are connected to each electrode 23, 24 and passed down through two separate holes in the ceramic cylinder 26.

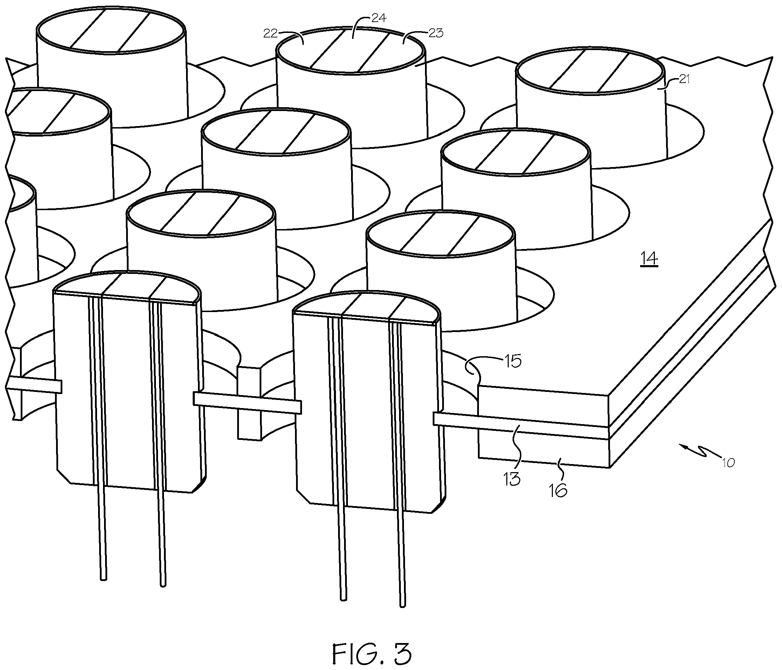

**Figure 3** shows in detail the pogo-like electrostatic chucks 21 pressed into the compliant sheet 13, such as a PFA fluoropolymer film and arranged in a matrix to cover large areas of a substrate. Using a compliant material in the sandwich of the chassis 12 (i.e., the resilient sheet 13 sandwiched between the two rigid panels 14, 16) allows each pogo-like element 21 to translate independently of one another in the vertical direction, as well as to tilt in all directions in order to optimize surface contact with the substrate (work piece) at discreet element locations. Each pogo is capable of withstanding a process temperature of 850° C. around the middle of the ceramic cylinder a groove is cut for the purpose of the cylinder being retained by a flexible sheet as shown in Figure 3. The capture of the flexible sheet allows the pogo to tilt and adjust vertically to compensate for the variation in localized surface flatness of the substrate. The flexible sheet is made from a high temperature polymer such as (but not limited to) PFA fluoropolymer film and is 0.3 mm to 0.5 mm thick depending on the elasticity of the selected material to provide the right degree of flexibility. To retain the flexible sheet a sandwich of thicker material such as (but not limited to) PFA fluoropolymer film which has a service temperature range of up to 260° C (which sets the temperature operational range of this flexible electrostatic chuck) is used to provide the control over how much flexibility the sheet sandwiched between the thicker matrix of holes has. Larger diameter holes provide the most leverage for tilt and up and down motion. The diameter of these guide holes may be in the range of 5 mm to 8 mm.

In one or more embodiments, the apparatus is adapted to withstand operating temperatures of up to about 260 degrees centigrade or more. Optimally, the apparatus is adapted to withstand operating temperatures of up to about 850 degrees centigrade.

Optionally, the resilient sheet comprises a PFA fluoropolymer film with a thickness of between about 0.3 millimeters and about 0.5 millimeters and the openings are cylindrical with a diameter of between about 5 millimeters and about 8 millimeters and the pins are cylindrical with a diameter of between about 2 millimeters and about 4 millimeters.

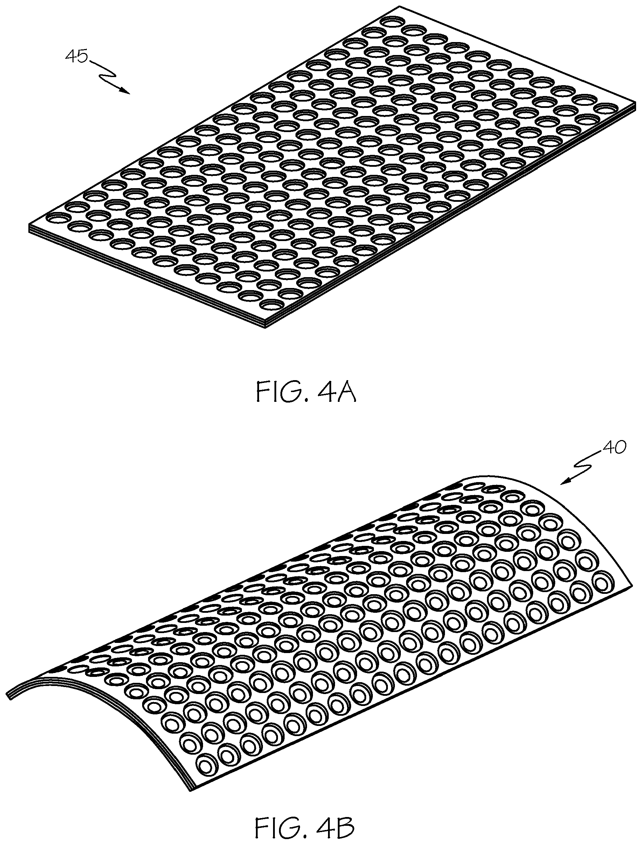

**Figure 4** shows an optional guide laminate structure 40 to retain a compliant flexible gasket, which in turn retains the pogo-like electrostatic chucks. Some optional configurations can include flat and rigid, flat and flexible, formed and rigid, formed and flexible, etc. In particular, **Figure 4** shows a curved guide laminate structure 40, while **Figure 4A** shows a flat guide structure 45.

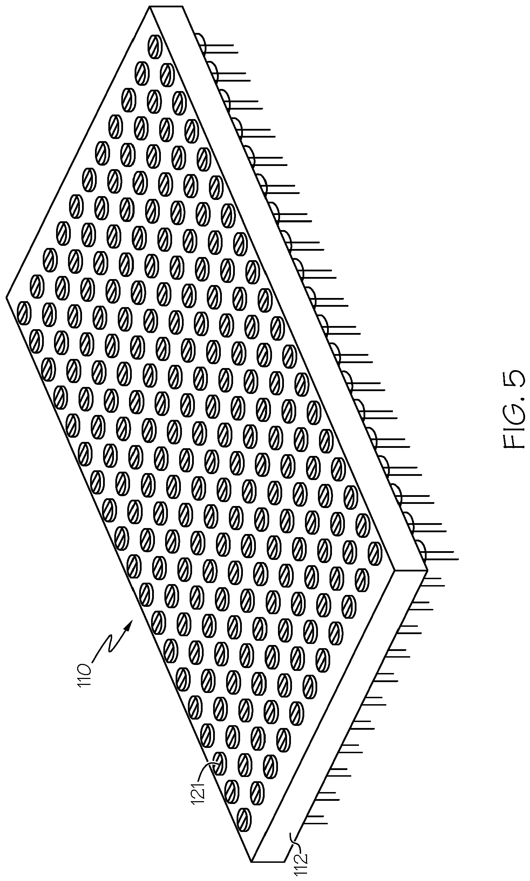

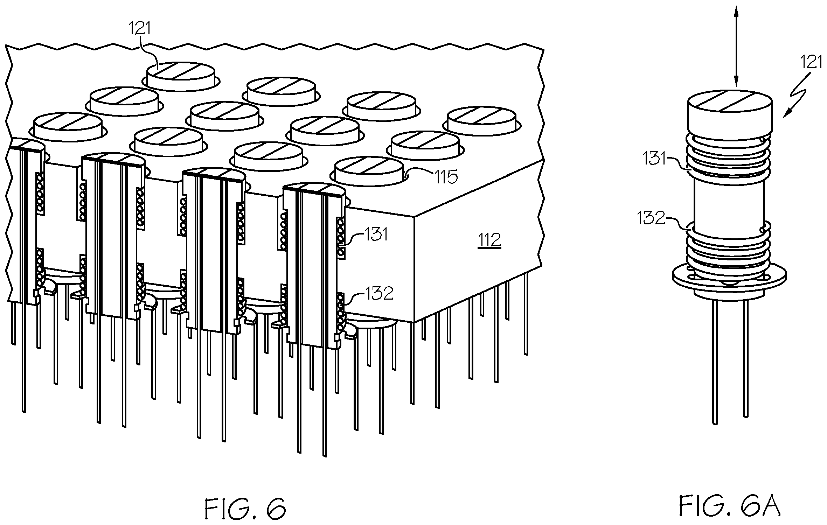

Optionally, as shown in **Figures 5-6A****,** the electrostatic chuck pins 121 of the apparatus 110 can be spring-mounted to the chassis 112. In this alternative embodiment, a similar construct of the pogo is shown in **Figure 1****,** but instead of using a flexible sheet to permit a range of motion, a dual spring mechanism is used to retain the pogo-like chuck pins 121. The pogo-like electrostatic chuck pins 121 in this embodiment have only a vertical motion capability, substantially without tilt, and in most cases the tilt is not required to overcome the variation in localized surface flatness of substrates. The pogo-like electrostatic chuck pin 121 is press fit into a rigid dielectric block 112, such as alumina - Al2O3 - with a matrix of holes 115 as shown in **Figures 5** and **6****.** Mechanical springs 131, 132 allow each pogo-like element 121 to translate independently in a vertical direction (transverse to the plane of the retaining block/plate 112), sliding within bores 115 formed in the rigid structure of the retaining block/plate 112. The advantage of this arrangement is that the temperature capability of this matrix of pogo electrostatic chucks is greatly enhanced and can operate in temperatures up to 850° C.

While the disclosure has been described in terms of various illustrative embodiments, those skilled in the art will appreciate that various changes, additions, deletions, and modifications can be made therein without departing from the scope of the appended claims. For example, the various aspects of the disclosure may be combined according to the following exemplary embodiments.
Embodiment 1. An electrostatic chuck apparatus for chucking glass, the apparatus comprising:
   a substantially rigid chassis having a plurality of apertures extending from one side of the chassis to another side of the chassis; and
   a plurality of electrostatic chuck pins extending through at least a portion of the plurality of the apertures and being resiliently mounted to the chassis such that the extent to which the electrostatic chuck pins extend through the chassis is individually variable, whereby the chuck pins contour to a surface of the chucking glass.
Embodiment 2. The electrostatic chuck apparatus of embodiment 1, wherein the surface of the chucking glass comprises a localized surface flatness in the range from about 10 µm to about 100 µm.
Embodiment 3. An electrostatic chuck apparatus as in Embodiment 1 or Embodiment 2 wherein the electrostatic chuck pins are spring-mounted to the chassis.
Embodiment 4. An electrostatic chuck apparatus as in any one of Embodiments 1-3 wherein the chassis comprises a resilient sheet attached to a rigid panel, and wherein the electrostatic chuck pins are mounted to the resilient sheet.
Embodiment 5. An electrostatic chuck apparatus as in Embodiment 4 further comprising a second rigid panel attached to the resilient sheet such that the resilient sheet is sandwiched between the two rigid panels.
Embodiment 6. An electrostatic chuck apparatus as in any one of Embodiments 1-5 wherein the electrostatic chuck pins are substantially cylindrical.
Embodiment 7. An electrostatic chuck apparatus as in any one of Embodiments 1-6 wherein the electrostatic chuck pins each comprise first and second electrodes separated from one another by a dielectric which maintains a gap between the electrodes.
Embodiment 8. An electrostatic chuck apparatus as in Embodiment 7 wherein the electrodes are positioned within a ceramic cylinder.
Embodiment 9. An electrostatic chuck apparatus as in any one of Embodiments 1-8 wherein the apparatus is adapted to withstand operating temperatures of up to about 260 degrees centigrade or more.
Embodiment 10. An electrostatic chuck apparatus as in Embodiment 4 wherein the resilient sheet comprises PFA fluoropolymer film with a thickness of between about 0.3 millimeters and about 0.5 millimeters.
Embodiment 11. An electrostatic chuck apparatus as in any one of Embodiments 1-10 wherein the openings are cylindrical with a diameter of between about 5 millimeters and about 8 millimeters and the pins are cylindrical with a diameter of between about 2 millimeters and about 4 millimeters.
Embodiment 12. An electrostatic chuck apparatus as in Embodiment 3 wherein the apparatus is adapted to withstand operating temperatures of up to about 850 degrees centigrade.

## Claims

1. An electrostatic chuck apparatus (10, 110) for chucking glass, the apparatus (10, 110) comprising:
a substantially rigid chassis (12, 112) having a plurality of apertures (15, 115) extending from one side of the chassis (12, 112) to another side of the chassis (12, 112); and
a plurality of electrostatic chuck pins (21, 121) extending through at least a portion of the plurality of the apertures (15, 115) and being resiliently mounted to the chassis (12, 112) such that the extent to which the electrostatic chuck pins (21, 121) extend through the chassis (12, 112) is individually variable, whereby the chuck pins contour to a surface of the glass.

2. An electrostatic chuck apparatus as claimed in Claim 1, wherein the electrostatic chuck pins (21, 121) are spring-mounted to the chassis (12, 112).

3. An electrostatic chuck apparatus as claimed in Claim 1 or Claim 2, wherein the chassis (12) comprises a resilient sheet (13) attached to a rigid panel (14), and wherein the electrostatic chuck pins (21) are mounted to the resilient sheet (13).

4. An electrostatic chuck apparatus as claimed in Claim 3, further comprising a second rigid panel (16) attached to the resilient sheet (13) such that the resilient sheet (13) is sandwiched between the two rigid panels (14, 16).

5. An electrostatic chuck apparatus as claimed in any one of Claims 1-4, wherein the electrostatic chuck pins (21) are substantially cylindrical.

6. An electrostatic chuck apparatus as claimed in any one of Claims 1-5, wherein the electrostatic chuck pins (21) each comprise first and second electrodes (23, 24) separated from one another by a dielectric which maintains a gap between the electrodes (23, 24).

7. An electrostatic chuck apparatus as claimed in Claim 6, wherein the electrodes (23, 24) are positioned within a ceramic cylinder (26).

8. An electrostatic chuck apparatus as claimed in Claim 3, wherein the resilient sheet (13) comprises PFA fluoropolymer film with a thickness of between about 0.3 millimeters and about 0.5 millimeters.

9. An electrostatic chuck apparatus as claimed in any one of Claims 1-8, wherein the openings are cylindrical with a diameter of between about 5 millimeters and about 8 millimeters and the pins are cylindrical with a diameter of between about 2 millimeters and about 4 millimeters.

## Patentansprüche

1. Elektrostatische Einspannvorrichtung (10, 110) zum Einspannen von Glas, die Vorrichtung (10, 110) Folgendes aufweisend:
ein im Wesentlichen starres Chassis (12, 112) mit mehreren Öffnungen (15, 115), die sich von einer Seite des Chassis (12, 112) zu einer anderen Seite des Chassis (12, 112) erstrecken; und
mehrere elektrostatische Einspannstifte (21, 121), die sich durch zumindest einen Abschnitt der mehreren Öffnungen (15, 115) erstrecken und derartig elastisch an dem Chassis (12, 112) angebracht sind, dass das Ausmaß, in dem sich die elektrostatischen Einspannstifte (21, 121) durch das Chassis (12, 112) erstrecken, individuell variabel ist, wodurch die Einspannstifte eine Oberfläche des Glases im Profil nachformen.

2. Elektrostatische Einspannvorrichtung nach Anspruch 1, wobei die elektrostatischen Einspannstifte (21, 121) federnd an dem Chassis (12, 112) angebracht sind.

3. Elektrostatische Einspannvorrichtung nach Anspruch 1 oder 2, wobei das Chassis (12) eine elastische Schicht (13) aufweist, die an einer starren Tafel (14) befestigt ist, und wobei die elektrostatischen Einspannstifte (21) an der elastischen Schicht (13) angebracht sind.

4. Elektrostatische Einspannvorrichtung nach Anspruch 3, weiterhin aufweisend eine zweite starre Tafel (16), die derartig an der elastischen Schicht (13) befestigt ist, dass die elastische Schicht (13) zwischen den beiden starren Tafeln (14, 16) eingefasst ist.

5. Elektrostatische Einspannvorrichtung nach einem der Ansprüche 1 bis 4, wobei die elektrostatischen Einspannstifte (21) im Wesentlichen zylindrisch sind.

6. Elektrostatische Einspannvorrichtung nach einem der Ansprüche 1 bis 5, wobei die elektrostatischen Einspannstifte (21) jeweils eine erste und eine zweite Elektrode (23, 24) aufweisen, die durch ein Dielektrikum voneinander getrennt sind, das eine Lücke zwischen den Elektroden (23, 24) erhält.

7. Elektrostatische Einspannvorrichtung nach Anspruch 6, wobei die Elektroden (23, 24) in einem Keramikzylinder (26) positioniert sind.

8. Elektrostatische Einspannvorrichtung nach Anspruch 3, wobei die elastische Schicht (13) einen PFA-Fluorpolymer-Film mit einer Dicke zwischen ungefähr 0,3 Millimeter und ungefähr 0,5 Millimeter aufweist.

9. Elektrostatische Einspannvorrichtung nach einem der Ansprüche 1 bis 8, wobei die Öffnungen zylindrisch sind mit einem Durchmesser zwischen ungefähr 5 Millimeter und ungefähr 8 Millimeter und die Stifte zylindrisch sind mit einem Durchmesser zwischen ungefähr 2 Millimeter und ungefähr 4 Millimeter.

## Revendications

1. Appareil de maintien électrostatique (10, 110) destiné à maintenir du verre, l'appareil (10, 110) comprenant :
un châssis sensiblement rigide (12, 112) ayant une pluralité d'ouvertures (15, 115) s'étendant d'un côté du châssis (12, 112) à un autre côté du châssis (12, 112) ; et
une pluralité de broches de maintien électrostatique (21, 121) s'étendant à travers au moins une partie de la pluralité d'ouvertures (15, 115) et étant montées de façon élastique sur le châssis (12, 112) de telle sorte que l'étendue sur laquelle les broches de maintien électrostatique (21, 121) s'étendent à travers le châssis (12, 112) est variable individuellement, les broches de maintien épousant ainsi une surface du verre.

2. Appareil de maintien électrostatique selon la revendication 1, dans lequel les broches de maintien électrostatique (21, 121) sont montées sur ressort sur le châssis (12, 112).

3. Appareil de maintien électrostatique selon la revendication 1 ou la revendication 2, dans lequel le châssis (12) comprend une feuille élastique (13) attachée à un panneau rigide (14), et dans lequel les broches de maintien électrostatique (21) sont montées sur la feuille élastique (13).

4. Appareil de maintien électrostatique selon la revendication 3, comprenant en outre un deuxième panneau rigide (16) attaché à la feuille élastique (13) de telle sorte que la feuille élastique (13) est intercalée entre les deux panneaux rigides (14, 16).

5. Appareil de maintien électrostatique selon l'une quelconque des revendications 1 à 4, dans lequel les broches de maintien électrostatique (21) sont sensiblement cylindriques.

6. Appareil de maintien électrostatique selon l'une quelconque des revendications 1 à 5, dans lequel les broches de maintien électrostatique (21) comprennent chacune des première et deuxième électrodes (23, 24) séparées l'une de l'autre par un diélectrique qui maintient un entrefer entre les électrodes (23, 24).

7. Appareil de maintien électrostatique selon la revendication 6, dans lequel les électrodes (23, 24) sont positionnées à l'intérieur d'un cylindre en céramique (26) .

8. Appareil de maintien électrostatique selon la revendication 3, dans lequel la feuille élastique (13) comprend un film de fluoropolymère de PFA avec une épaisseur comprise entre environ 0,3 millimètre et environ 0,5 millimètre.

9. Appareil de maintien électrostatique selon l'une quelconque des revendications 1 à 8, dans lequel les ouvertures sont cylindriques avec un diamètre compris entre environ 5 millimètres et environ 8 millimètres et les broches sont cylindriques avec un diamètre compris entre environ 2 millimètres et environ 4 millimètres.
